**Europäisches Patentamt**

**European Patent Office**

**Office européen des brevets**

(19)

(11) Numéro de publication : **0 018 860**
**B1**

(12)

# FASCICULE DE BREVET EUROPÉEN

(45) Date de publication du fascicule du brevet :
**02.05.84**

(51) Int. Cl.³ : **G 03 F   7/08**

(21) Numéro de dépôt : **80400403.4**

(22) Date de dépôt : **26.03.80**

(54) Compositions photopolymérisables filmogènes développables à l'eau et plaque lithographique.

(30) Priorité : **28.03.79 FR 7907746**

(43) Date de publication de la demande :
**12.11.80 Bulletin 80/23**

(45) Mention de la délivrance du brevet :
**02.05.84 Bulletin 84/18**

(84) Etats contractants désignés :
**AT BE CH DE GB IT LU NL SE**

(56) Documents cités :
**CH-A-   440 975**
**DE-A- 1 797 282**
**DE-A- 2 339 035**
**DE-A- 2 551 347**
**FR-A- 1 363 984**
**FR-A- 2 011 413**
**FR-A- 2 087 414**
**FR-A- 2 098 757**
**FR-A- 2 101 639**
**FR-A- 2 312 800**
**US-A- 3 829 369**

(73) Titulaire : **RHONE-POULENC SYSTEMES**
**39, boulevard des Bouvets**
**F-92000 Nanterre (FR)**

(72) Inventeur : **Pigeon, Marcel**
**64 rue de Longchamp**
**F-92200 Neuilly (FR)**
Inventeur : **Szretter, Marta**
**6, rue de Longpont**
**F-92200 Neuilly (FR)**
Inventeur : **Perle, Chantal**
**71, rue Championnet**
**F-75018 Paris (FR)**

(74) Mandataire : **Chichery, Guy**
**RHONE-POULENC RECHERCHES Centre de Recherches de Saint-Fons Service Brevets B.P. 62**
**F-69190 Saint-Fons (FR)**

Jouve, 18, rue St-Denis, 75001 Paris, France

Compositions photopolymérisables filmogènes développables à l'eau et plaque lithographique

La présente invention concerne des compositions photopolymérisables négatives, filmogènes, oléophiles et solubles dans les solvants organiques, comportant une résine époxy et un composé diazoïque photosensible en tant qu'agent réticulant de ladite résine, compositions applicables sur des supports appropriés tels que les supports de plaques lithographiques, le polyester traité, etc... La technique de l'impression lithographique, pour laquelle les compositions selon l'invention sont plus spécialement destinées, est basée sur le principe de la non miscibilité des encres grasses et de l'eau et par la création sur un support de zones hydrophiles (retenant l'eau et repoussant l'encre grasse) et de zones encrophiles (retenant l'encre grasse et repoussant l'eau).

Après mouillage à l'eau de ce support, l'encre grasse appliquée sur toute la surface est retenue par les zones encrophiles et repoussée par les zones hydrophiles humidifiées.

Les couches photosensibles utilisables en lithographie sont de deux types :
— les couches dites positives avec lesquelles les zones non exposées à la lumière sont conservées comme zones image après développement,
— les couches dites négatives avec lesquelles les zones non exposées sont éliminées après développement.

Dans le cas des plaques lithographiques utilisant des compositions photosensibles négatives telles que celles qui font l'objet de la présente invention, on expose ladite plaque à la lumière ultraviolette à travers un négatif ayant des zones transparentes et des zones opaques, de sorte que les zones non exposées sont facilement éliminées par un révélateur qui n'attaque pas les zones exposées, mettant ainsi à nu le support hydrophile sous-jacent.

Les zones exposées sont les zones « image » qui reçoivent l'encre grasse, tandis que les zones non exposées sont les zones « non-image ».

A l'heure actuelle, la plupart des plaques lithographiques couramment employées en imprimerie, sont du type présensibilisées, c'est-à-dire revêtues d'une couche photosensible et prêtes à être insolées à travers un original à reproduire ayant un support transparent partiellement revêtu de zones opaques.

Lorsqu'on veut réaliser des plaques lithographiques telles que décrites ci-dessus, dans lesquelles les parties imprimantes sont obtenues par polymérisation d'une résine, on préfère généralement utiliser des résines ayant une ténacité et une dureté exceptionnelles afin de réaliser des plaques lithographiques permettant un très grand nombre de tirages. On sait que les résines époxy sont particulièrement bien adaptées dans ce but.

Le brevet français 2 011 413 qui correspond à l'art antérieur pertinent dans le domaine où se situe la présente demande décrit des compositions photosensibles négatives solubles dans les solvants organiques qui sont un mélange d'un produit photosensible et photodurcissable constitué d'un produit de condensation photosensible et hydrosoluble d'un composé de diazonium et d'un agent de condensation organique ayant réagi avec un agent de couplage organique qui rend ce produit insoluble dans l'eau, et d'une résine filmogène oléophile soluble dans les solvants organiques. Comme composés diazoïques photosensibles sont cités notamment les diazoaromatiques et de préférence la p-diazodiphénylamine et ses dérivés, condensés avec des agents de condensation organiques ayant des groupes carbonyles réactifs tels que les aldéhydes ou les acétals et en particulier la formaldéhyde ou le paraformaldéhyde. Les agents de couplage permettant de rendre ces produits moins ioniques et donc essentiellement solubles dans les solvants organiques sont en général, des composés aromatiques acides, tels que les acides phosphiniques, phosphoniques, sulfoniques et carboxyliques dérivés du benzène, du toluène et du naphtalène ainsi que leurs dérivés.

Les résines synthétiques mélangées avec ces produits peuvent être choisies parmi de nombreuses résines bien connues de l'homme de l'art : elles doivent être filmogènes, oléophiles, insolubles dans l'eau, etc... A titre d'exemples non limitatifs, sont cités notamment les résines époxy, phénoliques, acryliques, polyamides, polystyrène, chlorure de polyvinyle, acétate de polyvinyle, polyester, polyuré-thane, etc... D'après la description donnée dans ce brevet, lesdites compositions photopolymérisables peuvent être utilisées pour la réalisation de plaques lithographiques développables avec des solutions aqueuses ou sensiblement aqueuses.

On sait en effet, que les utilisateurs de plaques lithographiques préfèrent des plaques d'utilisation simple et le développement à l'eau, dans ce but, est très recherché.

Or, à l'heure actuelle, de telles plaques ayant une très grande durée de vie et développables à l'eau n'ont pas encore été réalisées. En effet, contrairement à l'enseignement du brevet susmentionné, les plaques lithographiques ou analogues, à base de résines époxy, qui y sont décrites, ne sont pas développables à l'eau seule, ainsi qu'on le verra par la suite.

On connaît également du brevet américain n° 3 396 019 des plaques présensibilisées ayant un support en aluminium traité avec un acide phosphonique ou l'un de ses dérivés, revêtu d'une couche de résine oléophile insoluble dans l'eau et d'un produit de condensation soluble dans l'eau d'un composé de diazonium, tel que la paradiazodiphénylamine condensée avec le formaldéhyde dans un milieu acide. La résine époxy est citée parmi d'autres résines pouvant convenir à la réalisation de plaques lithographiques. De telles plaques présentent également de nombreux inconvénients : tout d'abord, la composition photopolymérisable telle que décrite dans les exemples de réalisation de ce brevet est très difficile à réaliser en pratique. En effet, le milieu dans lequel s'effectue le mélange des deux composés de la composition photopolymérisable selon ce brevet est un milieu partiellement aqueux étant donné que le composé de diazonium utilisé n'est soluble qu'en milieu aqueux. Or, les résines époxy ont une très mauvaise affinité pour l'eau.

En réalisant des compositions telles que décrites dans ce brevet, on constate que lesdites compositions précipitent très facilement. De plus, de telles compositions ne sont pas filmogènes et lors de l'enduction en couches minces sur un support, on constate une séparation des constituants de la composition, le composé de diazonium se séparant de la résine. Par conséquent, de telles compositions sont inutilisables industriellement.

On sait également du brevet américain n° 3 794 576 que les résines époxy monomères ou prépolymères fluides à température ambiante peuvent être polymérisées à l'aide de certains sels de diazonium tels que les hexafluorophosphates, tétrachloroferrates, hexachlorostannates, hexafluoroarsenates, hexafluoroantimonates, etc... De telles compositions sont utilisables pour réaliser des images, les parties non exposées étant enlevées à l'aide de solvants appropriés.

Parmi les nombreuses applications connues dans ce domaine, aucune ne décrit une composition photopolymérisable à base de résine époxy développable à l'eau.

Un premier objet de l'invention est donc de fournir une composition photopolymérisable négative filmogène oléophile et soluble dans les solvants organiques constituée d'une résine époxy et d'un produit de réaction photosensible résultant de la réaction entre :

— un produit de condensation photosensible et hydrosoluble lui-même obtenu par condensation entre un composé de diazonium et un agent de condensation organique possédant des groupes carbonyles réactifs,

— et un agent de couplage organique

caractérisé en ce que l'agent de couplage organique est choisi de telle manière que le produit de réaction photosensible soit légèrement soluble dans l'eau en y précipitant sous forme d'une pâte lors de sa préparation en milieu aqueux et en ce que la résine époxy est un monomère ou un prépolymère fluide ayant un point de fusion mesuré selon la méthode de Durran inférieur ou égal à 38, et ayant un équivalent époxy inférieur à 350 ; cette composition peut être déposée sur un support puis exposée sélectivement à la lumière ultra-violette de façon à durcir les zones ainsi exposées et enfin enlevée dans les zones non exposées avec de l'eau. On a en effet constaté, de manière surprenante, qu'en utilisant des compositions photopolymérisables contenant des produits de réaction photosensibles, de préférence dérivés d'un composé de diazonium aromatique, tels que décrits ci-dessus et une résine époxy fluide à température ambiante (la fluidité de la résine s'appréciant en l'absence de solvant) et en déposant celles-ci sur un support approprié, les zones exposées à la lumière actinique durcissent, tandis que les zones non exposées peuvent être enlevées par simple rinçage à l'eau courante. Une telle particularité présente un intérêt pratique très important puisque l'on supprime ainsi l'utilisation de solvants ou de solutions aqueuses contenant un agent mouillant pour le développement desdites compositions. Ainsi, une plaque lithographique revêtue d'une couche d'une composition photopolymérisable telle que décrite ci-dessus, peut être insolée, développée et séchée en quelques minutes.

Lorsque l'on utilise des résines époxy fluides de viscosité inférieure à 5 000 centipoises, il devient dans certains cas, difficile d'obtenir une couche photopolymérisable selon l'invention qui, après dépôt sur un support, soit non collante.

Le caractère de fluidité des résines époxy utilisées dans le cadre de la présente invention peut être défini comme dans le brevet américain n° 3 794 576. Une méthode qui peut être utilisée pour définir la limite de fluidité des résines selon l'invention est, par exemple, la méthode de DURRAN utilisant le mercure et dans laquelle on considère que le point de fusion d'une résine époxy est la température à laquelle la résine fondue atteint le sommet de mercure. Cette méthode est décrite en détails dans l'ouvrage « ANALYTICAL CHEMISTRY OF POLYMERS » Part I — pages 155-156, aux éditions GOLDON M. KLINE — INTERSCIENCE PUBLISHERS INC. NEW YORK. En réalisant cette méthode de mesure, on a constaté qu'il était préférable que les résines époxy utilisées dans la couche de la présente invention aient un point de fusion inférieur ou égal à environ 38 °C.

On constate toutefois que l'on n'obtient, dans ce cas, un développement à l'eau que pendant les quelques jours qui suivent l'enduction tout en obtenant la plus grande finesse de traits avec les trames utilisées pour la reproduction d'une image.

Par contre, lorsque le point de fusion, selon la méthode de DURRAN, de la résine époxy utilisée est inférieur ou égal à environ 27 °C, le développement à l'eau de la composition photopolymérisable selon l'invention, est possible pendant une dizaine de jours, dans les mêmes conditions que précédemment.

Pour obtenir un développement à l'eau après plusieurs dizaines de jours ou de mois de stockage de la composition photosensible (ce qui est souhaitable dans le cas de plaques offset présensibilisées, par exemple) la Demanderesse a constaté qu'il était préférable d'utiliser des résines époxy ayant un point de fusion DURRAN inférieur ou égal à environ 20 °C.

Sans pour autant être liée à une quelconque théorie, la Demanderesse pense qu'à l'intérieur des limites fixées ci-dessus, pour la résine époxy, l'addition de produit de réaction photosensible augmente la viscosité de la composition photopolymérisable et permet d'obtenir une couche non collante.

Par équivalent époxy, il faut entendre le poids en grammes de résine qui contient un équivalent-gramme d'époxy. Dans le cadre de la présente invention, il sera toutefois préférable d'utiliser des résines époxy ayant un équivalent époxy inférieur ou égal à 200 : dans le cas où l'on désire obtenir une couche ayant une bonne dureté, il est préférable d'avoir le plus grand nombre possible de groupements époxy, c'est-à-dire un équivalent époxy inférieur ou égal à 200.

D'une façon générale, on trouvera une description détaillée sur les résines époxy dans les pages 312 à 329 du premier volume supplémentaire de « ENCYCLOPEDIA OF CHEMICAL TECHNOLOGY » édité par KIRK and OTHMER et publié par INTERSCIENCE ENCYCLOPEDIA INC. NEW YORK, 1957, ainsi qu'aux pages 340 à 528 du libre « Epoxyverbinduengen und Epoxy harze » édité par PAQUIN et publié par SPRINGER-VERLAG, BERLIN, GOTTINGEN und HEIDELBERG, 1958. Les résines époxy convenant plus particulièrement dans le cadre de l'invention, sont les éthers glycidiques du bisphénol A ainsi que les résines époxy novalaques phénol ou crésol. Parmi les éthers glycidiques du bisphénol A, la Demanderesse préfère utiliser les éthers diglycidiques. De telles résines fluides à température ambiante peuvent être utilisées seules ou en mélanges, de façon à ajuster éventuellement leur viscosité.

On peut par exemple avantageusement dans certains cas particuliers, utiliser une résine époxy de viscosité inférieure à 5 000 centipoises en mélange avec une résine époxy de viscosité supérieure et obtenir ainsi un mélange pouvant être développé à l'eau pendant plusieurs mois ou années. On peut de même utiliser des mélanges comportant au moins une résine de viscosité inférieure à 5 000 centipoises et au moins une résine ayant un point de fusion DURRAN supérieur à 20 °C, et obtenir un mélange pouvant parfaitement être développé à l'eau plusieurs mois après son enduction sur un support. L'homme de l'art pourra ainsi réaliser toutes sortes de mélanges suivant le but recherché, lesdits mélanges étant compris dans le cadre de la présente invention. Pour plus de détails concernant les caractéristiques et mode de préparation des résines époxy fluides, on pourra se reporter avantageusement au brevet US n° 3 794 576.

A titre non limitatif, les résines époxy fluides couramment disponibles dans le commerce et qui conviennent dans le cadre de la présente invention sont :
— dans les produits vendus par la Société CIBA GEIGY sous la marque ARALDITE, les références GY 255, GY 260 ainsi que les références EPN 1138 et EPN 1139.
— Dans les produits vendus par la Société SHELL sous les marques EPON EPIKOTE, les références 827, 828, 834, etc...

D'une façon générale, les composés de diazonium utilisables dans les compositions photopolymérisables selon l'invention, sont des produits photosensibles, à fonction négative, et hydrosolubles tels que les diazo aromatiques et plus particulièrement les diazo arylamines éventuellement substitués sur le noyau aromatique ou sur le groupe amino. De préférence, on utilisera la paradiazodiphénylamine. Ces composés de diazonium sont condensés avec des agents de condensation organiques possédant des groupes carbonyles réactifs choisis de préférence parmi les aldéhydes ou les acétals. On peut citer en particulier, le formaldéhyde et le paraformaldéhyde. De tels produits et leur procédé de préparation sont décrits dans le brevet anglais n° 418 011.

Comme agents de couplage, on utilisera des produits permettant d'obtenir un produit de réaction photosensible, tel que défini ci-dessus, ayant une bonne solubilité dans les solvants organiques mais peu solubles dans l'eau. Il est en effet, très important que le produit de réaction photosensible soit légèrement soluble dans l'eau : on a en effet constaté que si ce produit était totalement insoluble dans l'eau, on ne pouvait obtenir un développement à l'eau de ladite composition photosensible. D'une manière générale, il est nécessaire d'utiliser des agents de couplage organiques qui tendent à diminuer le caractère ionique desdits composés de diazonium de façon à obtenir un produit de réaction soluble dans les solvants organiques et peu solubles dans l'eau. Il est possible au cours de la préparation en milieu aqueux du produit de réaction, de se rendre compte immédiatement si celui-ci convient ou non dans les compositions photopolymérisables de l'invention : lorsqu'on utilise un agent de couplage organique ayant un ou plusieurs substituants électro-négatifs forts, tels qu'un groupe nitré ou un halogène, on obtient un produit de réaction qui précipite immédiatement et que l'on peut filtrer facilement. Un tel produit est insoluble dans l'eau et ne convient donc pas dans le cadre de la présente invention : après application sur un support, de telles compositions ne peuvent être développées qu'à l'aide d'une solution aqueuse d'acide. Par contre, lorsque le produit de réaction est convenable, il précipite, au cours de la préparation sous forme d'une pâte qui doit être ensuite redissoute dans un autre solvant. De préférence, on utilisera comme agent de couplage organique des acides arylsulfoniques et en particulier les acides alkylaryl sulfoniques. Par alkyl, on entend une chaîne carbonée comportant moins de 10 atomes de carbone, éventuellement substituée. De préférence, on utilisera un acide alkylarylsulfonique possédant un ou plusieurs substituants choisis parmi l'hydrogène, les groupes méthyl et éthyl. Le terme aryl, quant à lui, désigne un noyau aromatique, simple ou condensé. De préférence, on utilisera toutefois un noyau aromatique simple, car il est possible dans certains cas de ne pas obtenir un développement à l'eau très facile avec des noyaux aromatiques condensés.

Par exemple, on a constaté que les acides mono ou polysulfoniques du naphtalène, éventuellement substitués, ne conviennent pas très bien comme agent de couplage de la paradiazodiphénylamine condensée formaldéhyde : le développement à l'eau est dans ce cas précis, très difficile. C'est pourquoi la Demanderesse préfère choisir l'agent de couplage parmi les acides benzène sulfonique, toluène sulfonique et diméthylbenzènesulfonique, de préférence le 2,5 diméthylbenzènesulfonique.

4

La Demanderesse a également constaté que le choix du substituant sur le noyau aromatique de l'acide de couplage arylsulfonique avait une influence directe sur le comportement du sel de cet acide avec la paradiazodiphénylamine, condensée avec un produit de condensation tel que défini auparavant ainsi que sur le développement de la composition photopolymérisable selon l'invention. Sans vouloir être liée par une quelconque théorie, la Demanderesse considère que l'influence des substituants sur les groupes fonctionnels est représentée par l'équation :

$$\rho\sigma = \log(K/Ko)$$

(équation de Hammett — Physical organic Chemistry — G.P. Hammett Mac Graw Hill — 1940) équation dans laquelle Ko et K sont des constantes de vitesse de réaction, $\sigma$ est le coefficient de substituant et $\rho$ est le coefficient d'une réaction définie.

D'après cette équation, les substituants attracteurs d'électrons ont un coefficient $\sigma$ positif par rapport à l'hydrogène dont le coefficient est égal à 0.

Les substituants donneurs d'électrons ont un coefficient négatif par rapport à l'hydrogène.

A titre indicatif, le tableau ci-dessous donne la valeur de $\sigma$ pour un certain nombre de substituants :

| Substituants | Valeur de $\sigma$ |
|---|---|
| H | 0 |
| p. Cl | + 0,227 |
| p. Br | + 0,232 |
| p. NO | + 0,778 |
| m. NO$_2$ | + 0,710 |
| p. CH$_3$ | − 0,170 |
| p. OC$_2$H$_5$ | − 0,250 |
| p. OCH$_3$ | − 0,268 |
| p. C$_2$H$_5$ | − 0,151 |
| m. CH$_3$ | − 0,069 |
| p.i. C$_3$H$_7$ | − 0,151 |
| p. tert C$_4$H$_9$ | − 0,197 |
| 3,4 di(CH$_3$) | − 0,229 |

Dans le cadre de la présente invention, la Demanderesse a constaté que le coefficient $\sigma$ des substituants qui conviennent, est généralement négatif ou nul.

Pour préparer un produit de réaction photosensible convenant dans le cadre de la présente invention, on prépare tout d'abord un sel de paradiazodiphénylamine condensée avec un agent de condensation organique ayant de préférence des groupes carbonyles réactifs, selon l'enseignement du brevet anglais n° 418 011. De tels produits condensés avec le paraformaldéhyde sont couramment disponibles dans le commerce. On réalise ensuite une solution aqueuse du composé de diazonium ainsi condensé en présence d'acide. On ajoute alors à cette solution sous forte agitation, une solution d'acide arylsulfonique. Lorsque le produit de réaction photosensible obtenu précipite sous forme d'une pâte collante (le coefficient $\sigma$ du substituant de l'acide arylsulfonique utilisé étant alors négatif), ceci indique que ledit produit de réaction photosensible a une certaine solubilité dans l'eau et qu'il convient dans le cadre de la présente invention. Ladite pâte est alors séparée du milieu réactionnel puis redissoute dans un solvant, ce qui permet d'obtenir une solution stable plusieurs dizaines de jours. On peut obtenir le produit sous forme solide en précipitant la solution ci-dessus avec un solvant adéquat.

Les compositions photopolymérisables selon l'invention, sont généralement appliquées sur un support. Lorsqu'on désire obtenir une couche non collante à température ambiante, afin notamment de pouvoir toucher ladite couche sans la marquer ni la détériorer, il est généralement nécessaire de réaliser des compositions comportant de 40 % à 70 % en poids de produit de réaction photosensible et de 30 % à 60 % en poids de résine époxy.

La demanderesse préfère que lesdites compositions comportent de 45 % à 60 % de produit de réaction photosensible et de 40 % à 55 % en poids de résine époxy.

Afin de rendre visibles pour l'opérateur les parties de la couche ayant été réticulées, on peut incorporer dans la composition selon l'invention, un ou plusieurs indicateurs colorés susceptibles de se colorer en milieu acide. De préférence, afin de ne pas gêner le développement à l'eau de ladite couche, on préférera limiter le poids de colorant à moins de 10 % du poids de la composition photopolymérisable. D'une façon générale, une quantité inférieure à 5 % en poids convient parfaitement. Pour obtenir un développement facile à l'eau courante, il convient de ne pas déposer une couche trop épaisse de composition photopolymérisable selon l'invention. On a constaté d'une manière générale que l'on obtenait d'excellents résultats en déposant de 0,5 g/m$^2$ à 2 g/m$^2$ de couche photopolymérisable et de préférence de 1 g/m$^2$ à 1,5 g/m$^2$.

Lorsqu'on dépose une couche trop faible de composition photopolymérisable, on risque évidemment, surtout lorsque le support présente une certaine rugosité (plaques lithographiques en particulier) de ne pas avoir une couche suffisamment homogène et constante sur tout le support.

Au-delà de 2 g/m², il devient parfois difficile d'enlever la couche non exposée avec de l'eau seule.

L'application la plus importante de l'invention est la réalisation de plaques lithographiques négatives, de préférence présensibilisées. Dans ce cas, on utilisera un support hydrophile choisi parmi les supports bien connus de l'homme de l'art, tels que le chrome, l'aluminium, éventuellement anodisé, l'acier inoxydable, l'acier étamé, le polyester dont la surface a été rendue hydrophile.

La préparation d'une plaque lithographique selon l'invention, s'effectuera de manière habituelle bien connue de l'homme de l'art en déposant de préférence de 0,5 g/m² à 2 g/m² et plus particulièrement de 1 g/m² à 1,5 g/m².

Après insolation à travers un négatif semi-transparent, les parties non insolées sont enlevées par simple rinçage à l'eau avec une douchette. La qualité des points obtenus est exceptionnelle ainsi qu'on le verra dans les exemples de réalisation.

L'invention sera mieux comprise à l'aide des exemples de réalisation suivants donnés à titre non limitatif :

## Exemple 1

Préparation de paratoluènesulfonate de paradiazodiphénylamine condensé formaldéhyde

Dans un ballon tricol muni d'un puissant agitateur et d'une ampoule à décanter, on place 26 g d'acide p. toluènesulfonique et 150 ml d'eau distillée.

On ajoute lentement et sous une forte agitation une solution de 36 g de diazo Fairmount n° 4 (qui est un sulfate de paradiazodiphénylamine condensé formaldéhyde) dans 300 ml d'eau et 50 ml acide phosphorique à 10 %. Le produit précipite en forme d'une pâte collante sur les parois du ballon. En fin d'addition, on laisse la réaction se poursuivre pendant 30 minutes, puis on décante la partie liquide et on lave le résidu dans le ballon deux fois avec 200 ml d'eau distillée. On dissout la pâte dans 600 g d'éther monométhylique d'éthylène glycol. La solution est stable à la température ambiante.

Pour obtenir le produit solide, on précipite la solution ci-dessus dans l'isopropanol. Après filtration et séchage sous vide à la température ambiante, on obtient 40 g de produit solide.

Préparation d'une plaque lithographique

On dissout 3 g de résine époxy novolaque 1139 de la Société CIBA GEIGY, 0,1 g de colorant rouge de méthyle dans 62 g d'éther monométhylique d'éthylène glycol (« Méthylcellosolve »). On y ajoute 33 g d'une solution de p. toluène sulfonate de p. diazodiphénylamine condensé formaldéhyde à 6 % dans le méthylcellosolve. La résine époxy 1139 a un équivalent époxy compris entre 172 et 179, une viscosité à 52 °C de 1 700 cps et une température de fusion DURRAN de 18 °C. Sur une plaque d'acier cuivrée, chromée, traitée à la gomme arabique, dégommée, rincée puis séchée, on enduit à l'aide d'une tournette à 50 t/mn pendant 30″ la solution ci-dessus.

On sèche la couche dans la tournette pendant 5′ à 40 °C, puis en étuve pendant 5′ à 85 °C. Le poids de couche déposé est de 1,5 g/m². On expose la plaque ainsi traitée à travers un montage négatif sous une lampe à arc du type NUARC 2 KW, distante de 60 cm pendant 1′. On obtient une image violette visible en lumière blanche et en lumière inactinique.

On développe la plaque au jet d'eau ; les parties non insolées gonflent et sont entraînées. On termine le développement en frottant légèrement à l'aide d'un tampon.

La qualité de la copie obtenue est excellente. Pour mesurer une telle qualité, on utilise les différentes gammes tramées du commerce :

La gamme UGRA représente les différentes plages tramées des trames offset de 60 lignes et 120 lignes par cm. La gamme comporte 12 plages reproduisant tous les points de 4 % à 96 % de surface couverte, couvrant toute la gamme des demi-teintes à reproduire, que l'on rencontre en imprimerie.

La gamme FOGRA, par contre, permet de mesurer avec précision le pouvoir de résolution de la plaque, car elle comporte des lignes en positif et en réserve (négatif) dont les épaisseurs sont mesurées en microns : 4, 6, 8, 10, etc...

La gamme UGRA copiée sur la plaque de cet exemple, est parfaitement reproduite dans toutes les valeurs y compris les points les plus fins de la trame 120 lignes/cm.

On obtient de même les traits positifs de 4 microns de la gamme FOGRA et les traits négatifs en réserve de 6 microns. La plaque calée sur machine n'a donné aucun signe d'usure après 75 000 tirages.

## Exemple 2

On prépare dans les mêmes conditions que dans l'exemple 1, une solution photosensible contenant 2 g de résine époxy novolaque 1139 de la Société CIBA GEIGY, 0,05 g de colorant rouge de méthyle dans 45 g de méthylcellosolve : on y ajoute 50 g d'une solution de p. toluène sulfonate de p. diazodiphénylamine condensé formaldéhyde à 6 % dans le méthylcellosolve.

On applique cette solution sur une plaque d'acier, cuivrée, chromée traitée de la même façon que dans l'exemple 1 (poids déposé : 1,5 g/m²).

Après exposition de la plaque à la lumière actinique à travers un original négatif semi-transparent, on développe celle-ci à l'eau comme dans l'exemple 1. On obtient les mêmes résultats que dans l'exemple 1, en particulier les traits de 6 microns positifs et négatifs de la gamme FOGRA.

### Exemple 3

On prépare dans les mêmes conditions que dans l'exemple 1, une solution photosensible contenant 3 g de résine ARALDITE 260 de la Société CIBA GEIGY, 0,075 g de rouge de méthyle dans 62 g de méthylcellosolve et on ajoute 33 g d'une solution à 6 % dans le méthylcellosolve de p. toluène solfonate de p. diazodiphénylamine condensé formaldéhyde. La résine époxy ARALDITE 260 a un équivalent époxy compris entre 185 et 196, une viscosité à 25 °C de 12 000 à 16 000 cps et un point de fusion DURRAN de 10 °C.

On applique cette solution sur une plaque d'aluminium anodisée traitée pour l'utilisation offset séchée avant enduction, dans les mêmes conditions que dans l'exemple 1.

Après exposition, on développe la plaque à l'eau comme dans l'exemple 1.

On obtient les mêmes résultats que dans l'exemple 1.

### Exemple 4

On prépare dans les mêmes conditions que dans l'exemple 1 une solution photosensible contenant 2 g de résine ARALDITE 255 de la Société CIBA GEIGY, 0,1 g de colorant rouge de méthyle dans 45 g de méthylcellosolve. On y ajoute 50 g d'une solution de p. toluène sulfonate de p. diazodiphénylamine condensé formaldéhyde à 6 % dans le méthylcellosolve.

La résine époxy ARALDITE 255 a un équivalent époxy compris entre 180 et 200, une viscosité à 25 °C comprise entre 5 000 et 6 000 cps et un point de fusion DURRAN de 5 °C.

On applique cette solution dans les mêmes conditions que dans l'exemple 1, sur une plaque d'acier étamé chromé, comme décrit dans la demande de brevet français n° 78 04 213 déposée le 15 Février 1978, au nom de la Demanderesse et intitulée « Nouveau support de plaque lithographique et procédé de mise en œuvre ». Après exposition, on développe la plaque à l'eau dans les mêmes conditions que dans l'exemple 1. On obtient les mêmes résultats que dans l'exemple 1.

### Exemple 5

On prépare dans les mêmes conditions que l'exemple 1, une solution photosensible contenant 2 g de résine EPIKOTE 828 de la Société SHELL, 0,075 g de rouge de méthyle dans 45 g de méthylcellosolve. On y ajoute 50 g d'une solution de p. toluène sulfonate de p. diazodiphénylamine condensé formaldéhyde à 6 % dans le méthyl cellosolve. La résine EPIKOTE 828 a un équivalent époxy compris entre 184 et 194, une viscosité de 10 000 à 15 000 cps à 25 °C et un point de fusion DURRAN de 10 °C.

On applique cette solution sur une plaque d'acier cuivré chromé traitée de la même façon que pour l'exemple 1 (poids déposé : 1,5 g/m²).

Après insolation, on développe à l'eau comme dans l'exemple 1. On obtient les mêmes résultats que dans l'exemple 1.

### Exemple 6

On prépare dans les mêmes conditions que pour l'exemple 1, une solution photosensible contenant 1 g de résine époxy novolaque 1139 de la Société CIBA GEIGY et 2 g de résine EPIKOTE 827 de la Société SHELL, 0,05 g de colorant rouge de méthyle dans 60 g de méthylcellosolve.

La résine EPIKOTE 827 a un équivalent époxy compris entre 180 et 190, une viscosité comprise entre 8 000 et 12 000 cps à 25 °C et un point de fusion DURRAN de 7 °C.

On y ajoute 33 g d'une solution de p. toluène sulfonate de p. diazodiphénylamine condensé formaldéhyde à 6 % dans le méthylcellosolve. On applique cette solution sur une plaque d'acier cuivré chromé traité comme dans l'exemple 1. On procède ensuite comme dans l'exemple 1 et on obtient les mêmes résultats.

### Exemple 7

Synthèse du benzène sulfonate de p. diazodiphénylamine condensé formaldéhyde

Dans un ballon tricol muni d'un puissant agitateur et d'une ampoule à décanter, on introduit 24 g de benzènesulfonate de sodium, 200 ml d'acide phosphorique à 10 %.

On ajoute sous une forte agitation une solution de 36 g de diazo FAIRMOUNT N° 4 dans 360 ml d'eau. Le produit précipite sous forme d'une pâte collante. On décante la partie liquide et on lave le résidu avec de l'eau distillée.

On dissout le produit dans 600 g d'éther monométhylique d'éthylène glycol. Pour obtenir le produit solide, on le précipite dans l'isopropanol et on le sèche sous vide.

Réalisation d'une plaque lithographique

On dissout 3 g de résine époxy novolaque 1139 et 0,1 g de 4 phénylazodiphénylamine dans 95 g de méthylcellosolve et on ajoute 2 g de benzène sulfonate de p. diazodiphénylamine condensé formaldéhyde : On obtient une solution photosensible à 5 % de solide dans le méthylcellosolve.

La solution obtenue est enduite sur un support chromé, insolée et développée à l'eau comme dans l'exemple 1. On obtient les mêmes résultats.

### Exemple 8

Préparation du 2,5 diméthylbenzène sulfonate de p. diazodiphénylamine condensé formaldéhyde

Dans un ballon tricol muni d'un puissant agitateur et d'une ampoule à décanter, on introduit 28,8 g d'acide 2,5 diméthylbenzène sulfonique, 200 ml d'eau et 50 ml d'acide phosphorique à 10 %. On ajoute sous forte agitation une solution de 36 g de diazo FAIRMOUNT N° 4 dans 360 ml d'eau. Le produit précipite sous forme d'une pâte collante que l'on lave à l'eau distillée.

On dissout le produit dans 600 g d'éther monométhylique d'éthylène glycol pour obtenir une solution prête à l'emploi. Si l'on veut obtenir un produit solide, il faut le précipiter dans l'isopropanol et le sécher sous vide.

Réalisation d'une plaque lithographique

On dissout 2,5 g de résine EPN 1139 et 0,1 g de colorant rouge de méthyle dans 55,5 g de méthylcellosolve. On y ajoute 42 g d'une solution de 2-5 diméthylbenzène sulfonate de p. diazodiphénylamine condensé formaldéhyde à 6 % dans le méthylcellosolve.

On applique cette solution sur une plaque d'acier chromé et l'on insole et développe la plaque comme dans l'exemple 1.

On obtient une image visible violette qui se développe parfaitement à l'eau. La qualité de la copie est excellente : en particulier les traits positifs et négatifs de 6 microns de la gamme FOGRA sont très nets.

Les résultats suivants sont des exemples comparatifs réalisés à partir de l'état de l'art et qui montrent combien l'invention est surprenante et non évidente :

### Exemple 9

Cet exemple correspond à l'enseignement du brevet américain n° 3 396 099.

On prépare une solution photosensible contenant 0,4 g d'un condensat de 3,3 g de paraformaldéhyde et 29 g de 4 diazodiphénylamine sulfate dans 42 g d'acide phosphonique à 85 % sans séparation de l'acide phosphonique et 0,8 g d'une résine époxy EPIKOTE 1001 de la Société SHELL, dans 86 g de méthylcellosolve et 5 g d'eau.

On applique cette solution sur un support chromé dans une tournette à 50 t/mn pendant 30 secondes puis on sèche la plaque ainsi obtenue pendant 5 mn à 40 °C puis 5' à 85 °C en étuve.

On expose la plaque ainsi traitée à travers un négatif sur un châssis de type $N_u$ Arc 2 KW pendant 1 mn, la distance d'insolation étant de 60 cm.

Le passage de la plaque dans l'eau ne provoque aucun développement. La plaque est développée à l'aide d'une solution aqueuse contenant 8 % de gomme arabique. Les parties non insolées se dissolvent partiellement : le sel de diazonium s'en va mais la résine époxy reste accrochée sur le support. On le constate au moment de l'encrage de la plaque qui devient toute noire sans aucune distinction entre les zones « image » et « non image », du fait de la présence de la résine époxy encrophile sur toute la plaque. Le résultat est identique sur support aluminium anodisé : la résine époxy n'est pas enlevée dans les zones « non-image » par le révélateur aqueux constitué d'eau et de 8 % de gomme arabique.

### Exemple 10

Cet exemple correspond à l'enseignement du brevet français n° 2 011 413

On prépare la solution suivante :

| | |
|---|---|
| Résine EPON 1031 (résine solide de la Société SHELL) | 2 g |
| 2 hydroxy 4 méthoxybenzophénone 5 sulfonate de p. diazodiphénylamine condensé formaldéhyde | 5 g |
| Méthylcellosolve | 93 g |

**0 018 860**

Cette solution est enduite sur un support chromé à raison de 1,5 g/m² environ puis séchée pendant 5 mn à 40 °C et pendant 5 mn à 85 °C.

La plaque ainsi obtenue est insolée pendant 1 mn à travers un négatif à l'aide d'un châssis de type Nu Arc de 2 KW. La distance d'insolation est de 60 cm.

On soumet la plaque à l'action d'un jet d'eau : on ne constate aucun développement. Si l'on utilise un révélateur aqueux contenant environ 20 % d'agent mouillant du type lauryl sulfate, on obtient, après action mécanique d'un tampon pendant 3 mn, une élimination des zones non insolées. Toutefois, on constate également que la couche a été partiellement éliminée dans les zones insolées, ce qui procure une copie de mauvaise qualité, ayant de nombreux défauts.

### Exemple 11

Cet exemple correspond également à l'enseignement du brevet français n° 2 011 413
On prépare la solution suivante :

| | |
|---|---|
| Résine EPIKOTE 1001 (résine de la Société SHELL) | 2 g |
| 2 hydroxy 4 méthoxybenzophénone 5 sulfonate de p. diazodiphénylamine condensé formaldéhyde | 5 g |
| Méthylcellosolve | 93 g |

Cette solution est déposée sur un support chromé à raison de 1,5 g/m² environ, puis séchée comme dans l'exemple précédent. La plaque est ensuite insolée à travers un négatif comme dans l'exemple précédent.

L'action d'un jet d'eau et d'un tampon ne permet pas le développement de la plaque.

Comme dans l'exemple précédent, la plaque est développée à l'aide d'un révélateur aqueux contenant 20 % d'agent mouillant du type laurylsulfate, avec action mécanique d'un tampon. La qualité de l'image obtenue est mauvaise comme dans l'exemple précédent.

### Exemple 12

Cet exemple correspond à l'enseignement du brevet américain n° 4 104 772
On prépare la solution A suivante :

| | |
|---|---|
| Chlorozincate de paradiazodiphénylamine condensé paraformaldéhyde | 2 g |
| Eau | 50 g |
| Méthanol | 50 g |

On prépare ensuite la solution B suivante :

| | |
|---|---|
| 2 hydroxy 4 méthoxybenzophénone 5 sulfonate de paradiazodiphénylamine condensé formaldéhyde | 1 g |
| Résine époxy EPON 1031 | 2 g |
| Méthylcellosolve | 97 g |

La solution A est déposée à raison de 1,5 g/m² environ sur un support en aluminium anodisé traité pour l'utilisation en lithographie. Après séchage de la couche, on dépose à raison de 1,5 g/m² environ la solution B qui est ensuite séchée comme dans les exemples précédents. On réalise l'insolation de la plaque à travers un négatif pendant 2 mn, comme dans l'exemple précédent. On soumet ensuite la plaque à l'action d'un jet d'eau et d'un tampon : on ne constate aucun développement.

### Exemple 13

Cet exemple correspond également à l'enseignement du brevet américain n° 4 104 072).

On réalise la même expérience que dans l'exemple 10, en remplaçant la résine EPON 1031 par la résine EPON 1007. On obtient les mêmes résultats négatifs.

### Exemple 14

On prépare la solution suivante :

| | |
|---|---|
| Résine EPIKOTE 1007 (résine solide de la Société SHELL) | 2 g |
| p. toluène sulfonate de p. diazodiphénylamine condensé formaldéhyde | 4 g |
| Méthylcellosolve | 94 g |

Cette solution est déposée sur un support chromé puis insolée dans les mêmes conditions que dans l'exemple 9. Par action d'un jet d'eau et d'un tampon, le sel de diazonium est éliminé dans les zones non exposées mais la résine reste dans lesdites zones, même après 5 mn de développement. Lorsque la plaque est recouverte d'encre noire, on obtient une surface noire uniforme, sans distinction des zones « image » et « non image ».

## Exemple 15

On prépare de même, une solution photosensible contenant 3 g de résine époxy novolaque 1139, 95 g de méthylglycol et 2 g de sel de fluoroborate du 3,6-diéthoxy 4 morpholino fluoro diazobenzène. On applique cette solution comme dans les exemples précédents. Après insolation, le développement à l'eau est impossible, et il faut utiliser une solution d'acide phosphorique à 20 % environ. Toutefois, les parties insolées sont fragiles et partiellement éliminées.

## Exemple 16

On procède de la même manière que dans l'exemple 13, mais en préparant le sel p. toluène sulfonate du diazo précédent.

On obtient le même résultat négatif.

Il est évident que les compositions photopolymérisables selon l'invention, sont également applicables pour la réalisation de plaques lithographiques du type « wash-off » ainsi que dans tous les cas où un tel procédé est utilisé (pour plus de détails sur un tel procédé, voir l'ouvrage « Light sensitive systems » de J. KOSAR — p. 114-118). Les compositions photopolymérisables décrites ci-dessus sont bien entendu, également polymérisables à l'aide de radiations électromagnétiques de longueur d'ondes appropriées (faisceaux d'électrons ou « électron-beam »).

Par contre, on a constaté que les compositions photopolymérisables selon l'invention, ne sont pas utilisables sur un support tel que le cuivre, car non développables à l'eau dans ce cas.

## Revendications

1. Composition photopolymérisable négative filmogène oléophile et soluble dans les solvants organiques constituée d'une résine époxy et d'un produit de réaction photosensible résultant de la réaction entre :
— un produit de condensation photosensible et hydrosoluble lui-même obtenu par condensation entre un composé de diazonium et un agent de condensation organique possédant des groupes carbonyles réactifs,
— et un agent de couplage organique
caractérisé en ce que l'agent de couplage organique est choisi de telle manière que le produit de réaction photosensible soit légèrement soluble dans l'eau en y précipitant sous forme d'une pâte lors de sa préparation en milieu aqueux et en ce que la résine époxy est un monomère ou un prépolymère fluide ayant un point de fusion mesuré selon la méthode de Durran inférieur ou égal à 38, et ayant un équivalent époxy inférieur à 350.

2. Composition photopolymérisable selon la revendication 1 caractérisée en ce que la résine époxy a un équivalent époxy inférieur ou égal à 200.

3. Composition photopolymérisable selon la revendication 1 ou 2, caractérisée en ce que le point de fusion de la résine époxy mesuré selon la méthode de DURRAN est inférieur ou égal à 27 °C.

4. Composition photopolymérisable selon l'une des revendications 1 à 3, caractérisée en ce que le point de fusion de la résine époxy mesuré selon la méthode de DURRAN est inférieur ou égal à 20 °C.

5. Composition photopolymérisable selon l'une des revendications 1 à 4, caractérisée en ce que la viscosité de la résine époxy est supérieure ou égale à 5 000 centipoises à 25 °C.

6. Composition photopolymérisable selon l'une des revendications 1 à 5, caractérisée en ce que la résine époxy est choisie parmi les éthers diglycidiques du bisphénol A.

7. Composition photopolymérisable selon l'une des revendications 1 à 6, caractérisée en ce que le composé de diazonium est une diazoarylamine, éventuellement substituée.

8. Composition photopolymérisable selon l'une des revendications 1 à 7, caractérisée en ce que le composé de diazonium est choisi parmi la paradiazodiphénylamine et ses dérivés.

9. Composition photopolymérisable selon l'une des revendications 1 à 8, caractérisée en ce que l'agent de condensation organique est un aldéhyde ou un acétal.

10. Composition photopolymérisable selon l'une des revendications 1 à 9, caractérisée en ce que l'agent de condensation organique est le formaldéhyde ou le paraformaldéhyde.

11. Composition photopolymérisable selon l'une des revendications 1 à 10, caractérisée en ce que l'agent de couplage organique est un acide arylsulfonique éventuellement substitué.

12. Composition photopolymérisable selon la revendication 11, caractérisée en ce que le coefficient $\sigma$ du substituant de l'acide arylsulfonique est négatif ou nul.

13. Composition photopolymérisable selon la revendication 11, caractérisée en ce que l'acide arylsulfonique comporte un ou plusieurs substituants alkyl ou alkoxy.

14. Composition photopolymérisable selon la revendication 11, caractérisée en ce que l'acide arylsulfonique comporte un ou plusieurs substituants choisis parmi H, CH₃ ou C₂H₅.

15. Composition photopolymérisable selon l'une des revendications 1 à 14, caractérisée en ce que l'agent de couplage organique est choisi parmi les acides benzène sulfonique, toluène sulfonique ou diméthylbenzène sulfonique de préférence 2,5 diméthylbenzène sulfonique.

16. Composition photopolymérisable selon l'une des revendications 1 à 15, caractérisée en ce qu'elle comporte de 40 % à 70 % en poids de produit de réaction photosensible et de 30 % à 60 % en poids de résine époxy.

17. Composition photopolymérisable selon l'une des revendications 1 à 16, caractérisée en ce qu'elle comporte de 45 % à 60 % en poids de produit de réaction photosensible et de 40 % à 55 % en poids de résine époxy.

18. Plaque lithographique négative constituée d'un support hydrophile revêtu d'une couche photosensible imprimante destinée à être exposée sélectivement à la lumière actinique de façon à durcir les zones exposées, caractérisée en ce que la couche photosensible est conforme à l'une des revendications 1 à 17, les zones non exposées à la lumière actinique pouvant être enlevées avec de l'eau.

**Claims**

1. Film forming negative photopolymerisable composition which is oleophilic and soluble in organic solvents and which consists of an epoxy resin and a photosensitive reaction product resulting from the reaction between :
— a photosensitive and water-soluble condensation product itself obtained by condensation between a diazonium compound and an organic condensation agent possessing reactive carbonyl groups
— and an organic coupling agent,
characterised in that the organic coupling agent is chosen in such a way that the photosensitive reaction product is slightly soluble in water and precipitates from water in the form of a paste during its preparation in an aqueous medium and in that the epoxy resin is a monomer or a fluid prepolymer having a melting point, measured by the Durran method, less than or equal to 38 °C, and having an epoxy equivalent of less than 350.

2. Photopolymerisable composition according to Claim 1, characterised in that the epoxy resin has an epoxy equivalent of less than or equal to 200.

3. Photopolymerisable composition according to Claim 1 or 2, characterised in that the melting point of the epoxy resin measured by the Durran method is less than or equal to 27 °C.

4. Photopolymerisable composition according to one of Claims 1 to 3, characterised in that the melting point of the epoxy resin measured by the Durran method is less than or equal to 20 °C.

5. Photopolymerisable composition according to one of Claims 1 to 4, characterised in that the viscosity of the epoxy resin is greater than or equal to 5,000 centipoises at 25 °C.

6. Photopolymerisable composition according to one of Claims 1 to 5, characterised in that the epoxy resin is chosen from amongst the diglycidyl ethers of bisphenol A.

7. Photopolymerisable composition according to one of Claims 1 to 6, characterised in that the diazonium compound is an optionally substituted diazoarylamine.

8. Photopolymerisable composition according to one of Claims 1 to 7, characterised in that the diazonium compound is chosen from amongst para-diazodiphenylamine and its derivatives.

9. Photopolymerisable composition according to one of Claims 1 to 8, characterised in that the organic condensation agent is an aldehyde or an acetal.

10. Photopolymerisable composition according to one of Claims 1 to 9, characterised in that the organic condensation agent is formaldehyde or paraformaldehyde.

11. Photopolymerisable composition according to one of Claims 1 to 10, characterised in that the organic coupling agent is an optionally substituted arylsulphonic acid.

12. Photopolymerisable composition according to Claim 11, characterised in that the σ-coefficient of the substituent of the arylsulphonic acid is negative or zero.

13. Photopolymerisable composition according to Claim 11, characterised in that the arylsulphonic acid contains one or more alkyl or alkoxy substituents.

14. Photopolymerisable composition according to Claim 11, characterised in that the arylsulphonic acid contains one or more substituents chosen from amongst H, CH₃ or C₂H₅.

15. Photopolymerisable composition according to one of Claims 1 to 14, characterised in that the organic coupling agent is chosen from amongst benzenesulphonic acid, toluenesulphonic acid or dimethylbenzenesulphonic acid, preferably 2,5-dimethylbenzenesulphonic acid.

16. Photopolymerisable composition according to one of Claims 1 to 15, characterised in that it contains from 40 % to 70 % by weight of photosensitive reaction product and from 30 % to 60 % by weight of epoxy resin.

17. Photopolymerisable composition according to one of Claims 1 to 16, characterised in that it contains from 45 % to 60 % by weight of photosensitive reaction product and from 40 % to 55 % by weight of epoxy resin.

18. Negative lithographic plate consisting of a hydrophilic carrier coated with a photosensitive printing layer intended to be exposed selectively to actinic light so as to harden the exposed zones, characterised in that the photosensitive layer is in accordance with one of Claims 1 to 17, and the zones not exposed to actinic light can be removed with water.

**Ansprüche**

1. Photopolymerisierbare filmbildende oleophile und in organischen Lösungsmitteln lösliche Zusammensetzung für Negativfilm, bestehend aus einem Epoxyharz und einem lichtempfindlichen Reaktionsprodukt, das durch die Umsetzung von :

— einem lichtempfindlichen und wasserlöslichen Kondensationsprodukt, das selbst durch Kondensation einer Diazoniumverbindung mit einem organischen Kondensationsmittel, das reaktive Carbonylgruppen enthält, erhalten wurde,

— mit einem organischen Kupplungsmittel

erhalten wurde, dadurch gekennzeichnet, daß das organische Kupplungsmittel in solcher Weise ausgewählt ist, daß das lichtempfindliche Reaktionsprodukt, das bei seiner Herstellung in einem wäßrigen Milieu in Form einer Paste ausfällt, in Wasser schwach (légèrement) löslich ist und daß das Epoxyharz eine monomere oder eine vorpolymere fließfähige Substanz mit einem Schmelzpunkt, gemessen nach dem Verfahren von Durran, von niedriger als oder gleich 38 °C und mit einem Epoxyäquivalent von niedriger als 350 ist.

2. Photopolymerisierbare Zusammensetzung nach Anspruch 1, dadurch gekennzeichnet, daß das Epoxyharz ein Epoxyäquivalent von niedriger als oder gleich 200 hat.

3. Photopolymerisierbare Zusammensetzung nach Anspruch 1 oder 2, dadurch gekennzeichnet, daß der Schmelzpunkt des Epoxyharzes, gemessen nach dem Verfahren von Durran, niedriger als oder gleich 27 °C ist.

4. Photopolymerisierbare Zusammensetzung nach einem der Ansprüche 1 bis 3, dadurch gekennzeichnet, daß der Schmelzpunkt des Epoxyharzes, gemessen nach dem Verfahren von Durran, niedriger als oder gleich 20 °C ist.

5. Photopolymerisierbare Zusammensetzung nach einem der Ansprüche 1 bis 4, dadurch gekennzeichnet, daß die Viskosität des Epoxyharzes oberhalb von oder gleich 5 000 Centipoise bei 25 °C ist.

6. Photopolymerisierbare Zusammensetzung nach einem der Ansprüche 1 bis 5, dadurch gekennzeichnet, daß das Epoxyharz aus der Gruppe von Diglycidäthern von Bisphenol A ausgewählt ist.

7. Photopolymerisierbare Zusammensetzung nach einem der Ansprüche 1 bis 6, dadurch gekennzeichnet, daß die Diazoniumverbindung ein gegebenenfalls substituiertes Diazoarylamin ist.

8. Photopolymerisierbare Zusammensetzung nach einem der Ansprüche 1 bis 7, dadurch gekennzeichnet, daß die Diazoniumverbindung aus der Gruppe von p-Diazodiphenylamin und dessen Derivaten gewählt ist.

9. Photopolymerisierbare Zusammensetzung nach einem der Ansprüche 1 bis 8, dadurch gekennzeichnet, daß das organische Kondensationsmittel ein Aldehyd oder ein Acetal ist.

10. Photopolymerisierbare Zusammensetzung nach einem der Ansprüche 1 bis 9, dadurch gekennzeichnet, daß das organische Kondensationsmittel Formaldehyd oder para-Formaldehyd ist.

11. Photopolymerisierbare Zusammensetzung nach einem der Ansprüche 1 bis 10, dadurch gekennzeichnet, daß das organische Kupplungsmittel eine gegebenenfalls substituierte Arylsulfonsäure ist.

12. Photopolymerisierbare Zusammensetzung nach Anspruch 11, dadurch gekennzeichnet, daß der $\sigma$-Koeffizient des Substituenten der Arylsulfonsäure negativ oder Null ist.

13. Photopolymerisierbare Zusammensetzung nach Anspruch 11, dadurch gekennzeichnet, daß die Arylsulfonsäure einen oder mehrere Alkyl- oder Alkoxysubstituenten umfaßt.

14. Photopolymerisierbare Zusammensetzung nach Anspruch 11, dadurch gekennzeichnet, daß die Arylsulfonsäure einen oder mehrere Substituenten aus der Gruppe von H, $CH_3$ und $C_2H_5$ umfaßt.

15. Photopolymerisierbare Zusammensetzung nach einem der Ansprüche 1 bis 14, dadurch gekennzeichnet, daß das organische Kupplungsmittel aus der Gruppe von Benzolsulfonsäure, Toluolsulfonsäure oder Dimethylbenzolsulfonsäure, vorzugsweise 2,5-Dimethylbenzolsulfonsäure, gewählt ist.

16. Photopolymerisierbare Zusammensetzung nach einem der Ansprüche 1 bis 15, dadurch gekennzeichnet, daß sie 40 bis 70 Gew.% des lichtempfindlichen Reaktionsproduktes und 30 bis 60 Gew.% des Epoxyharzes enthält.

17. Photopolymerisierbare Zusammensetzung nach einem der Ansprüche 1 bis 16, dadurch gekennzeichnet, daß sie 45 bis 60 Gew.% des lichtempfindlichen Reaktionsproduktes und 40 bis 55 Gew.% des Epoxyharzes enthält.

18. Lithographische Negativplatte, bestehend aus einem hydrophilen Träger, der mit einer lichtempfindlichen Druckschicht überzogen ist, die für ein selektives Belichten mit aktinischem Licht in der Weise vorgesehen ist, daß die belichteten Zonen gehärtet werden, dadurch gekennzeichnet, daß die lichtempfindliche Schicht einem der Ansprüche 1 bis 17 entspricht und die mit aktinischem Licht nichtbelichteten Zonen mit Wasser entfernt werden können.